# EUROPÄISCHE PATENTSCHRIFT

(11) **EP 3 013 996 B1**
(45) Veröffentlichungstag und Bekanntmachung des Hinweises auf die Patenterteilung: **10.05.2017**
(21) Anmeldenummer: 14732919.7
(22) Anmeldetag: 26.06.2014
(51) Int. Cl.: C23C 14/35, C23C 14/06

(54) **VERFAHREN ZUR HERSTELLUNG DEKORATIVER HIPIMS-HARTSTOFFSCHICHTEN**
PROCESS FOR MANUFACTURING OF DECORATIVE HIPIMS HARD MATERIAL LAYERS
PROCÉDÉ DE DÉPÔT DES COUCHES DÉCORATIVES DE SUBSTANCE DURE APPLIQUÉES PAR HIPIMS

(30) Priorität: 26.06.2013 US 201361839454 P
(43) Veröffentlichungstag der Anmeldung: 04.05.2016
(73) Patentinhaber: Oerlikon Surface Solutions AG, Pfäffikon, 8808 Pfäffikon (CH)
(72) Erfinder: KRASSNITZER, Siegfried, A-6800 Feldkirch (AT)
(74) Vertreter: Troesch Scheidegger Werner AG
(86) Internationale Anmeldenummer: PCT/EP2014/063611
(87) Internationale Veröffentlichungsnummer: WO 2014/207154

(56) Entgegenhaltungen:
- EP-A1- 2 492 251
- EP-B1- 1 614 764
- EHIASARIAN A P ET AL: "High power pulsed magnetron sputtered CrNx films", SURFACE AND COATINGS TECHNOLOGY, ELSEVIER, AMSTERDAM, NL, Bd. 163-164, 1. Januar 2003 (2003-01-01), Seiten 267-272, XP002445020, ISSN: 0257-8972, DOI: 10.1016/S0257-8972(02)00479-6
- ALAMI J ET AL: "On the relationship between the peak target current and the morphology of chromium nitride thin films deposited by reactive high power pulsed magnetron sputtering", JOURNAL OF PHYSICS D: APPLIED PHYSICS, INSTITUTE OF PHYSICS PUBLISHING LTD, GB, Bd. 42, Nr. 1, 015304, 7. Januar 2009 (2009-01-07), Seiten 1-7, XP020149023, ISSN: 0022-3727, DOI: 10.1088/0022-3727/42/1/015304
- EHIASARIAN A ET AL: "Influence of high power impulse magnetron sputtering plasma ionization on the microstructure of TiN thin films", JOURNAL OF APPLIED PHYSICS, AMERICAN INSTITUTE OF PHYSICS, US, Bd. 109, Nr. 10, 23. Mai 2011 (2011-05-23) , XP012146923, ISSN: 0021-8979, DOI: 10.1063/1.3579443
- MAGNUS F ET AL: "Comparison of TiN thin films grown on SiO2 by reactive dc magnetron sputtering and high power impulse magnetron sputtering", MATERIALS RESEARCH SOCIETY SYMPOSIUM PROCEEDINGS - MATERIALS, PROCESSES, AND RELIABILITY FOR ADVANCED INTERCONNECTS FOR MICRO- AND NANOELECTRONICS, Bd. 1335, 25. April 2011 (2011-04-25), Seiten 93-97, XP002728700, DOI: 10.1557/OPL.2011.1262
- MACHUNZE R ET AL: "Stress and texture in HIPIMS TiN thin films", THIN SOLID FILMS, Bd. 518, Nr. 5, 31. Dezember 2009 (2009-12-31), Seiten 1561-1565, XP026764013, ELSEVIER-SEQUOIA S.A. LAUSANNE, CH ISSN: 0040-6090, DOI: 10.1016/J.TSF.2009.09.069
- Robert Hallman: "MASTER'S THESIS A Study of TiN Coatings on Medical Implants Deposited by HiPIMS", , 21. Februar 2011 (2011-02-21), Seiten 1-91, XP055135111, Gefunden im Internet: URL:https://pure.ltu.se/portal/files/32579 478/LTU-EX-2011-32548427.pdf [gefunden am 2014-08-18]
- ROQUINY PH ET AL: "Colour control of titanium nitride coatings produced by reactive magnetron sputtering at temperature less than 100<o>C", SURFACE AND COATINGS TECHNOLOGY, Bd. 116-119, 1. September 1999 (1999-09-01), Seiten 278-283, XP027345985, ELSEVIER, AMSTERDAM, NL ISSN: 0257-8972

## Beschreibung

Die Erfindung bezieht sich auf ein Verfahren zum Beschichten von Substraten mit einer dekorativen Hartstoffschicht, welches in einer Vakuumbeschichtungskammer durchgeführt wird, wobei die dekorative Hartstoffschicht mittels eines reaktiven HIPIMS-Prozesses (High Power Pulse Magnetron Sputtering) abgeschieden wird, und wobei der Energieinhalt in Leistungspulsen derart reguliert wird, dass die abgeschiedene Hartstoffschicht eine homogene Farbe, eine hohe Glattheit und eine hohe Härte aufweist.

### Stand der Technik

Die Patentschrift US4415421A beschreibt ein Verfahren zur Herstellung von dekorativen goldfarbigen Schichten welches die Abscheidung einer tragfähigen Schutzschicht aus TiN mittels Elektronenstrahlverdampfung und die Abscheidung einer Gold-Schicht auf die Oberfläche der TiN-Schicht mittels Gold-Bedampfung umfasst.

Die Patentschrift EP0201508B1 beschreibt goldfarbene, mit Gold dotierte TiN-Schichten und deren Herstellungsverfahren.

In der Patentschrift DE3134587C2 wird es jedoch erwähnt, dass für die praktische Anwendung Gold als Material zur Herstellung von goldfarbenen Filmen nicht gut geeignet ist, weil es einerseits sehr teuer ist und anderseits keine gute Abriebfestigkeit aufweist und deshalb leicht beschädigt wird. Aus diesem Grund schlägt man in DE3134587C2 vor, eine Beschichtung zu verwenden, welche statt einer goldfarbenen Schicht aus Gold, eine goldfarbene Schicht aus einer Cu-Sn-Al-Legierung aufweist. Die goldfarbene Cr-Sn-Al-Schicht soll in der Beschichtung zwischen einer Primärbeschichtung und einer Endbeschichtung aufgebracht werden. Die Primär- und Endbeschichtungen können gemäß DE3134587C2 hergestellt werden indem man jeweils eine Anstrichfarbe aus einem Material wie Polyester, Acrylharz oder Polyurethan durch Aufsprühen oder Aufbürsten aufträgt, danach erhitzt und anschließend unter Erzielung einer vorgegebenen Dicke trocknet. Für die Endbeschichtung sollte eine durchsichtige Anstrichfarbe verwendet werden.

Eine weitere Möglichkeit einer goldfarbenen Beschichtung herzustellen ohne Gold als Schichtmaterial verwenden zu müssen, wird in der Offenlegungsschrift DE3150039A1 dargestellt. Gemäß DE3150039A1 wird eine goldfarbene goldfreie Schicht aus TiN und ZrN hergestellt, welche eine gute Abriebfestigkeit aufweist.

In ähnlicher Weise schlägt DE3731127C2 ein Verfahren zur dekorativen Beschichtung von Substraten vor, bei dem eine goldfarbige Schicht mittels kathodischer Lichtbogenverdampfung von einem Target aus einer Ti, Zr, oder TiZr-Legierung abgeschieden wird, wobei die Beschichtung in einer Stickstoffgas enthaltenden reaktiven Atmosphäre durchgeführt wird, und wobei das Target eine negative Spannung gegenüber der Anode aufweist. DE3731127C2 lehrt, dass unter Verwendung eines TiZr-Legierungstargets und Stickstoffgas goldfarbige Schichten hergestellt werden können, welche eine Zusammensetzung TiₓZr₁₋ₓN mit 0<x<1 aufweisen, und deren Farbeindruck mit x variiert. Ferner lehrt DE3731127C2, dass unter Verwendung eines Ti-Targets und Stickstoffgas als Reaktivgas und zusätzlich auch O₂- und/oder C-haltige Gase als Dotierungsgas goldfarbige TiN-Schichten hergestellt werden können, welche mit O₂ und/oder C dotiert sind, und deren Farbeindruck mit dem relativen Dotierungsgehalt variiert. Weiterhin lehrt DE3731127C2, dass unter Verwendung eines Zr-Targets und Stickstoffgas als Reaktivgas und zusätzlich auch O₂- und/oder C-haltige Gase als Dotierungsgas weißgoldfarbige ZrN-Schichten hergestellt werden können, welche mit O₂ und/oder C dotiert sind, und deren Farbeindruck mit dem relativen Dotierungsgehalt variiert.

Die Patentschrift EP1614764B1 beschreibt ein dekorativer Gegenstand mit einer goldfarbigen Beschichtung, deren Farbe durch die Abscheidung einer Vielzahl von übereinanderliegenden Paaren von abwechselnden TiN- und ZrN-Schichten erreicht wird, und wobei das Verhältnis zwischen dem Gewicht von Zr und der Summe der Gewichte von Zr und Ti in der Beschichtung zwischen 50% und 80% liegt. Einerseits sorgt diese mehrlagige Struktur für die Verleihung einer Farbe entsprechend derjenigen von Gold 2N18 oder 1N14 oder 3N18 und anderseits macht sie es möglich, dass bei Verschleiß der äußeren Schichten der Farbeeindruck immer noch erhalten bleibt. In EP1614764B1 wird es auch erwähnt, dass das Verfahren zur Abscheidung der dekorativen Schicht auf einem Gegenstand vorzugsweise ein Sputterverfahren sein soll, bei dem Ti- und Zr-haltigen Sputterquellen verwendet werden.

R. Hallman berichtet in seiner Magisterarbeit "A Study of TiN Coatings on Medical Implants Deposited by HiPIMS", welche an der Technische Universität Luleäin in Schweden durchgeführt wurde, dass er TiN-Schichten mit verschiedenen Farbeindrücken von goldgelb bis bräunlich mittels HIPIMS herstellen konnte. Hallmann erwähnt, dass ein starker Einfluss von bestimmten Schichteigenschaften, wie z.B., Porosität und Dichte, auf den Farbeindruck festgestellt werden konnte und auch eine leichte Korrelation zwischen Farbeindruck und Sauerstoffgehalt gefunden wurde.

In der Zeitschrift Surface and Coatings Technology 116-119 (1999) 278-283 berichtet Roquiny über den Einfluss des Stickstoffflusses auf die Farbe von TiN-Schichten, die unter Verwendung von reaktiven Sputter-Prozessen abgeschieden werden. Die Farbe der abgeschiedenen TiN-Schichten variierte gemäss Roquini vom metallischen Grau über Gold bis bräunlichem Rot bei Erhöhung des Stickstoffflusses.

A.P. Ehiasarian et. al. berichten in "influence of high power impulse magnetron sputtering plasma ionization on the microstructure of TiN thin films" Journal of applied physics 109, 104314 (2011) über die Abscheidung von TiN mittels HIPIMS. Jedoch bleibt die Erzeugung von homogenen Schichtfarben bei der Beschichtung mittels reaktiver Sputter- oder HIPIMS-Prozessen eine grosse Herausforderung.
Bei der Beschichtung mittels reaktiven Sputter- oder HIPIMS-Prozessen wird oft ein metallisches Target als Zerstäubungsmaterialquelle verwendet, dabei kommt zumindest ein Reaktivgas zum Einsatz, welches zumindest teilweise mit Material aus der Target-Oberfläche derart reagiert, dass Bereiche der Target-Oberfläche mit dem aus der Reaktion resultierenden, in der Regel keramischen, Material bedeckt werden. Der Abdeckungsgrad hängt von den Prozessparametern ab, beispielweise ganz stark vom Reaktivgasfluss. Dieses Phänomenon wird normalerweise Targetvergiftung genannt. Man sagt, dass ein Target komplett vergiftet ist, wenn die Target-Oberfläche total abgedeckt ist.
Grundsätzlich stellt die Targetvergiftung eine grosse Problematik für die Herstellung von dekorativen Schichten mittels reaktiver Sputter- oder HIPIMS-Prozesse dar, weil bei solchen Prozessen die Targetvergiftung normalerweise zum Auftreten von Hysterese-Verhalten hinsichtlich der Prozessparameter und in allgemeinen zu Prozessinstabilitäten führt.

Infolgedessen ist die industrielle Herstellung von dekorativen Schichten mit homogener Schichtfarbe mittels reaktiver Sputter- oder HIPIMS-Prozesse nicht wirtschaftlich, insbesondere nicht, wenn eine Beschichtungskammer mit grossen Dimensionen verwendet werden sollten, weil in diesem Fall die Inhomogenität der resultierende Schichtfarbe in den beschichteten Substrate, die über die Beschichtungskammer verteilt sind, noch grösser ist.

Ausserdem, gibt es eine zusätzliche Problematik bei der Verwendung von HIPIMS-Prozessen, nämlich, dass aufgrund der pulsmässigen Variation der eingesetzten Sputterleistung, Schwankungen der Reaktivpartialdruck in der Beschichtungskammer während des Beschichtungsprozesses auftreten, welche auch zu einer Inhomogenität der resultierenden Schichtfarbe führen.

### Aufgabe der vorliegenden Erfindung

Es ist die Aufgabe der vorliegenden Erfindung ein Verfahren zum Beschichten von Oberflächen von Substraten mit dekorativen Hartstoffschichten bereitzustellen, welches einerseits der beschichteten Oberflächen ein dauerhaftes farbiges Aussehen verleiht und andererseits eine einfache Einstellung eines homogenen Farbeindrucks ermöglicht.

### Beschreibung der vorliegenden Erfindung

Die Aufgabe der vorliegenden Erfindung wird durch die Bereitstellung eines Verfahrens nach Anspruch 1 gelöst.

Der Erfinder hat gefunden, dass es überraschenderweise möglich ist, Hartstoffschichten mit einem sehr homogenen Farbeindruck, einer sehr hohen Härte und einer sehr glatten Schichtoberfläche mittels reaktiver HIPIMS-Prozesse zu produzieren, welche aufgrund dieser Schichteigenschaften insbesondere für dekorative Anwendungen sehr gut geeignet sind, wenn beim HIPIMS-Prozess Leistungspulse und/oder Leistungspulssequenzen mit einem auf die Target-Fläche bezogenen Energieinhalt von mindestens, vorzugsweise grösser als 0.2 Joule/cm² pro Leistungspuls bzw. pro Leistungspulssequenz verwendet werden.
Unter einer Leistungspulssequenz verstehen wir ein Leistungspuls-Paket.

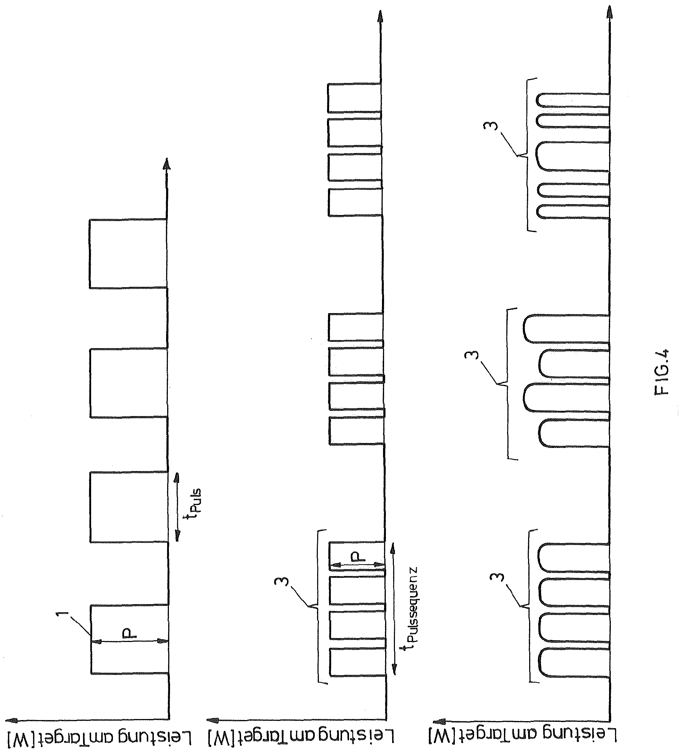

Die Figur 4 zeigt exemplarische Darstellungen von möglichen Leistungsverläufen am Target, um ein besseres Verständnis der im Rahmen der vorliegenden Erfindung verwendeten Begriffe zu schaffen.

Unter dem Begriff "Leistungspulse oder Leistungspulssequenz mit einem auf die Target-Fläche bezogenen Energieinhalt" versteht man im Sinne der vorliegenden Erfindung den gesamten Energieinhalt, der während der Puls-Dauer, t_{Puls}, eines Leistungspulses 1 oder während der Sequenz-Dauer, t_{Pulssequenz}, einer Leistungspulssequenz 3 in die Target-Flächeeingetragen wird, wobei als Target-Fläche die Fläche des Targets betrachtet wird, auf die das Plasma während der Puls-Dauer, t_{Puls}, des Leistungspulses 1 bzw. während der Sequenz-Dauer (Pulspaket-Dauer), t_{Pulssequenz}, der Leistungspulssequenz 3 effektiv projiziert wird. Diese Target-Fläche wird oft auch als "Racetrack" bezeichnet und ist am Target als Abtragfläche erkennbar

Der erfindungsgemäß in einem Leistungspuls 1 erforderliche Energieinhalt beim HIPIMS-Prozess kann beispielsweise durch die Einstellung einer entsprechend sehrhohen Pulsleistung, P, und/oder einer entsprechend sehr großen Pulslänge bzw. Pulsdauer, t_{Puls}, erreicht werden. Die entsprechende Pulsleistung, P, und Pulsdauer, t_{Puls}, können natürlich nur so groß eingestellt werden, dass das Targetmaterial in der entsprechenden Beschichtungskammeranordnung nicht thermisch überbelastet wird. In ähnlicher Weise kann der erfindungsgemäß gesamte, in einer Leistungspulssequenz 3 erforderliche Energieinhalt beim HIPIMS-Prozess durch die Einstellung der Pulsleistungen, P, der die Sequenz bzw. das Pulspaket bildenden Pulse innerhalb einer Leistungspulssequenz 3 und/oder durch die Einstellung der Sequenz-Dauer, t_{Pulssequenz}, der Leistungspulssequenz 3 erreicht werden.

Die erfindungsgemäß durchgeführten HIPIMS-Prozesse laufen sehr stabil und überraschenderweise weder die Prozessstabilität noch die Homogenität der für dekorative Anwendungen wichtigen Schichteigenschaften der auf diese Weise hergestellten Hartstoffschichten werden durch mögliche Targetvergiftungs-Erscheinungen und/oder Reaktivpartialdrückschwankungen beeinträchtigt.

Konkret betrifft die vorliegende Erfindung ein Verfahren zum Beschichten mindestens vonTeilbereichen der Oberfläche eines Substrats bzw. zur Herstellung von Substraten mit einem Oberflächenbereich mit einer dekorativen Hartstoffschicht in einer Beschichtungskammer, wobei zur Herstellung der Hartstoffschicht ein reaktiver HIPIMS-Prozess angewendet wird, bei dem mindestens ein Reaktivgas verwendet wird, und mindestens ein Target aus einem Material verwendet wird, welches bei der Durchführung des HIPIMS-Prozesses mit dem Reaktivgas derart reagieren kann, dass dadurch eine vorgegebene Schichtfarbe produziert wird, wobei der HIPIMS-Prozess unter Verwendung von Leistungspulsen und/oder von Leistungspulssequenzen mit einem auf die Target-Fläche bezogenen Energieinhalt von mindestens, vorzugsweise grösser als 0.2 Joule/cm² pro Leistungspuls bzw. pro Leistungspulssequenz durchgeführt wird und dadurch ein homogener Farbeindruck der Hartstoffschicht erzeugt wird.
Es kann nicht ausgeschlossen werden, dass nebst Leistungspulsen und/oder Leistungspulssequenzen (Leistungspuls-Paketen) die diese Forderungen erfüllen, auch Leistungspulse und/oder Leistungspulssequenzen (Leistungspuls-Pakete) eingesetzt werden können, die die genannte Forderung nicht erfüllen, nämlich bezüglich Energieinhalt. Dabei kann vermutet werden, dass mindestens 50% der aufgebrachten Leistungspulse und/oder Leistungspulssequenzen die genannte Forderung erfüllen sollten. In der heutigen Realisationsform erfüllen praktisch alle Leistungspulse bzw. Leistungspulssequenzen die genannte Forderung, bzw. die noch zu nennenden noch schärferen Forderungen.
Im weiteren kann ein gemischter Betrieb mit Leistungspulsen und mit Leistungspulssequenzen eingesetzt werden.
Im weiteren wird darauf hingewiesen, dass die thermische Belastung des Targets, nebst durch Pulsleistung und Pulsdauer bzw. durch Einzel-Pulsleistungen und Sequenz-Dauer (Pulspaket-Dauer) auch durch das gewählte Duty-Cyle bestimmt wird, d.h. durch
- das Verhältnis von Pulsdauer (ON-time) zu Pulsperiode (ON-time + OFF-time) bei Leistungspulsen bzw.
- das Verhältnis von Pulspaket-(Sequenz)Dauer zu Pulspaketperiode (Pulspaket ON-time + Pulspaket OFF-time).
Vorzugsweise wird der Energieinhalt von mindestens, vorzugsweise grösser als 0.2 Joule/cm² pro Leistungspuls bzw. pro Leistungspulssequenz unter der Einstellung einer Leistungsdichte von mindestens, vorzugsweise grösser als 100 W/cm² , vorzugsweise mit einer Stromdichte von mindestens, vorzugsweise grösser als 0.2 A/cm² eingebracht.

Gemäß einer bevorzugten Ausführungsform der vorliegenden Erfindung wird der HIPIMS-Prozess unter Verwendung von Leistungspulsen und/oder Leistungspulssequenzen mit einem auf die Target-Fläche bezogenen Energieinhalt von mindestens, vorzugsweise grösser als 1 Joule/cm² pro Leistungspuls bzw. pro Leistungspulssequenz durchgeführt.

Vorzugsweise wird dieser Energieinhalt pro Leistungspuls bzw. pro Leistungspulssequenz unter der Einstellung einer Leistungsdichte von mindestens, vorzugsweise grösser als 500 W/cm²,vorzugsweise mit einer Stromdichte von mindestens , vorzugsweise grösser als 1 A/cm² bzw. eingebracht.

Gemäß einer besonders bevorzugten Ausführungsform der vorliegenden Erfindung wird der HIPIMS-Prozess unter Verwendung von Leistungspulsen und/oder Leistungspulssequenzen mit einem auf die Target-Fläche bezogenen Energieinhalt von mindestens, vorzugsweise grösser als 10 Joule/cm² pro Leistungspuls bzw. pro Leistungspulssequenz durchgeführt.

Vorzugsweise wird dieser Energieinhalt unter einer Einstellung einer Leistungsdichte von mindestens, vorzugsweise grösser als 1000 W/cm², vorzugsweise mit einer Stromdichte von mindestens, vorzugsweise grösser als 2 A/cm² eingebracht.

Vorzugsweise wird die Konzentration des Reaktivgases in der Beschichtungskammer durch die Regulation - Steuerung oder Regelung - eines Reaktivgasflusses kontrolliert.

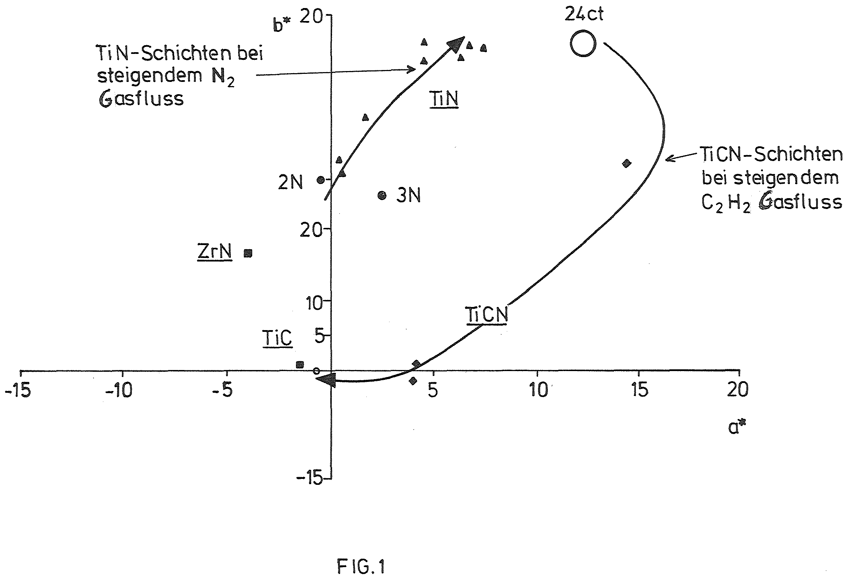

Die vorliegende Erfindung wird anschließend anhand von einigen Beispielen und von den Figuren 1 bis 3 weiter beschrieben:
Fig. 1 zeigt die CIELab Farbkoordinaten a* und b*, die von erfindungsgemäß hergestellten TiN- und TiCN-Schichten gemessen wurden, welche bei steigendem Stickstoffgasfluss bzw. bei steigendem Azetylen-Gasfluss abgeschieden wurden. Durch die Einstellung verschiedener Stickstoffgasflüsse konnten TiN-Schichten mit verschiedenen Goldstandards hergestellt werden. In ähnlicher Weise konnte man TiCN-Schichten mit verschiedenen Farben durch die Einstellung unterschiedlicher Azetylen-Gasflüsse herstellen.

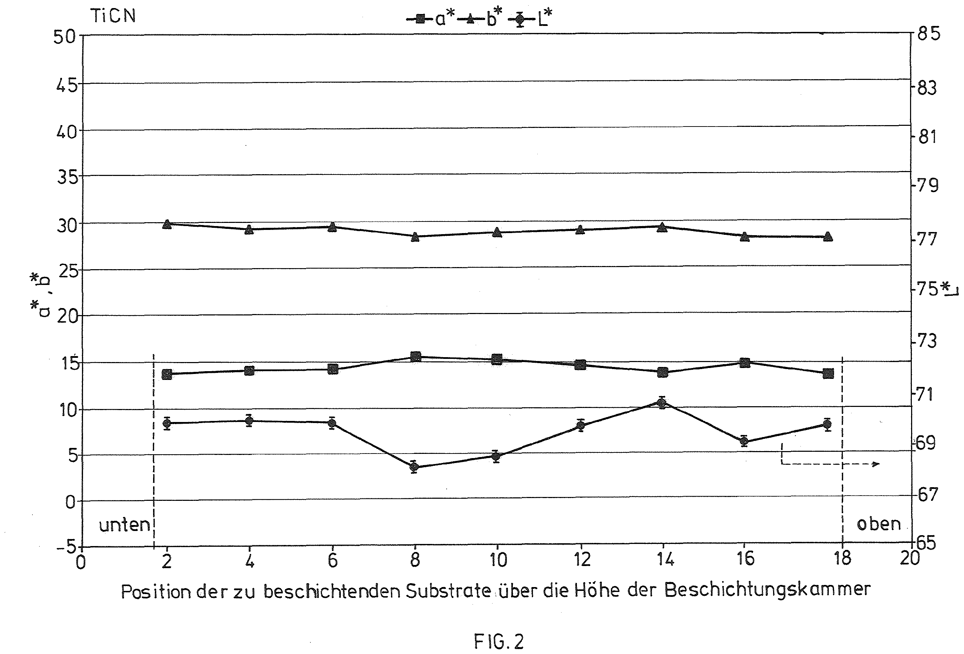

Fig. 2 zeigt die CIELab Farbkoordinaten a* und b* und die Helligkeitsfaktoren L*, die von erfindungsgemäß abgeschiedenen TiCN-Schichten gemessenen wurden, welche im gleichen Beschichtungsbatch aus Ti-Targets und unter Verwendung eines N₂- und C₂H₂-haltigen Reaktivgasflusses auf unterschiedlichen Substraten aufgebracht wurden. Die Substrate wurden vor dem Start des erfindungsgemäßen Beschichtungsverfahrens über die Höhe der Beschichtungskammer verteilt, um die Homogenität des Farbeindrucks über die Höhe der Beschichtungskammer zu überprüfen. Eine sehr gute Homogenität der Schichtfarbe innerhalb der Beschichtungskammer konnte bestätigt werden. Die Beschichtungshöhe bzw. die für die Beschichtung von Substraten definierte Höhe der Beschichtungskammer war in diesem Beispiel 400 mm, jedoch ist die Beschichtungshöhe für die Durchführung eines erfindungsgemäßen Prozesses nicht auf diese Höhe limitiert d.h. die Beschichtungshöhe kann auch kleiner oder grösser sein.

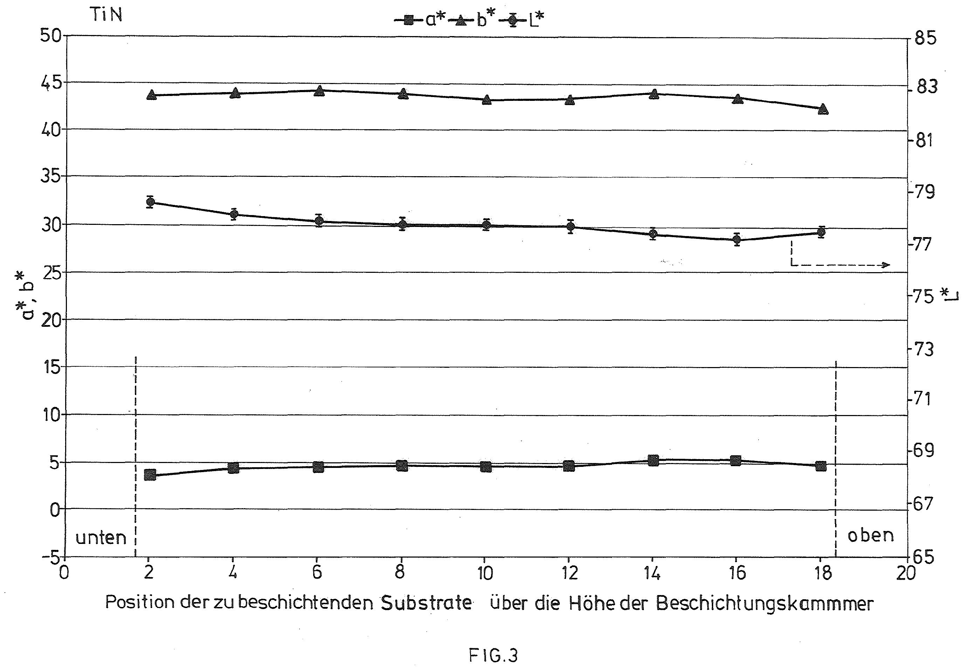

Fig. 3 zeigt die CIELab Farbkoordinaten a* und b* und die Helligkeitsfaktoren L*, die von erfindungsgemäß abgeschiedenen goldfarbigen TiN-Schichten gemessenen wurden, welche im gleichen Beschichtungsbatch aus Ti-Targets und unter Verwendung eines N₂-haltigen Reaktivgasflusses auf unterschiedlichen Substraten aufgebracht wurden. Die Substrate wurden vor dem Start des erfindungsgemäßen Beschichtungsverfahrens über die Höhe der Beschichtungskammer verteilt, um die Homogenität des goldenen Farbeindrucks über die Höhe der Beschichtungskammer zu überprüfen. Eine sehr gute Homogenität der Schichtfarbe innerhalb der Beschichtungskammer konnte bestätigt werden. Die Beschichtungshöhe bzw. die für die Beschichtung von Substraten definierte Höhe der Beschichtungskammer war in diesem Beispiel auch 400 mm, jedoch ist die Beschichtungshöhe für die Durchführung eines erfindungsgemäßen Prozesses nicht auf diese Höhe limitiert d.h. die Beschichtungshöhe kann auch kleiner oder grösser sein.

Eine hervorragende Homogenität des Farbeindrucks über die gesamte Beschichtungshöhe konnte bei den erfindungsgemäß abgeschiedenen TiCN- und TiN-Schichten bestätigt werden, wie es in den Fig. 2 und 3 zu sehen ist.

Goldfarbigen Schichten mit einer mehrlagigen Schichtstruktur aus mehreren alternierend-abgeschiedenen dünnen TiN-und ZrN-Schichten lassen sich auch unter Verwendung eines Verfahrens gemäß der vorliegenden Erfindung hervorragend herstellten. Beispielweise indem man bei gleichem HIPIMS-Beschichtungsprozess Stickstoffgas als Reaktivgas verwendet und mindestens ein HIPIMS-Target aus Ti und ein HIPIMS-Target aus Zr derart in der Beschichtungskammer positioniert und betreibt, dass auf die zu beschichtenden Substrate TiN- und ZrN-Schichten alternierend abgeschieden werden.
Gemäß der vorliegenden Erfindung können verschiedenen Farben des Goldstandards bei erfindungsgemäß abgeschiedenen Hartstoffschichten durch die Einstellung unterschiedlicher Stickstoffflüsse sehr einfach produziert werden, insbesondere bei der Verwendung von Ti-haltigen Targets oder vorzugsweise von Targets die aus Titan bestehen.
Erfindungsgemäß kann der Stickstofffluss genau so reguliert werden, dass der Farbeneindruck vorzugsweise einer Farbe entsprechend derjenigen von Gold 2N18 oder 1 N14 oder 3N18 entspricht.

Der Erfinder hat festgestellt, dass Hartstoffschichten mit schönen Farben für dekorative Anwendungen sich unter Verwendung von Targets, die Titan oder Titan und Aluminium oder Zirkon umfassen, herstellen lassen.
Gemäß einer bevorzugten Ausführungsform eines erfindungsgemäßen Verfahrens wird mindestens ein Target verwendet, welches aus Titan,aus Titan und Aluminium, oder aus Zirkon besteht.
Zur Herstellung von Nitriden, Oxiden, Carbiden, Oxinitriden oder Carbonitriden, welche den erfindungsgemäß hergestellten Schichten verschiedene Schichteigenschaften und Farbeindrücke geben können, kann Stickstoffgas oder Sauerstoffgas oder ein kohlenstoffhaltiges Gas, beispielweise C₂H₂ oder CH₄, oder eine Mischung derselben, bespielweise N₂ und C₂H₂, in die Beschichtungskammer zur Durchführung des HIPIMS-Prozesseses eingelassen werden.

Vorzugsweise wird eine Beschichtung gemäß der vorliegenden Erfindung auf Substrate appliziert, bei denen die Hartstoffschicht eine dekorative Funktion haben soll.

Die hier beschriebenen erfindungsgemäßen Verfahren eignen sich insbesondere sehr gut für die Beschichtung von unterschiedlichen dekorativen Gegenständen als Substrate, die auch aus unterschiedlichen Materialien bestehen können. Ein sehr großer Vorteil bei der Verwendung eines Verfahrens gemäß der vorliegenden Erfindung für die Herstellung von dekorativen Hartstoffschichten ist, dass man auch in der Lage ist temperaturempfindliche Substrate zu beschichten, welche beispielsweise Temperaturen über 200 °C nicht ausgesetzt werden dürfen. Das ist möglich, weil die erfindungsgemäßen HIPIMS-Prozesse derart durchgeführt werden können, dass die Dauer eines Leistungspulses, t_{Puls}, oder die Dauer der Einzel-Pulse innerhalb einer Leistungspulssequenz oder die Dauer einer Leistungspulssequenz, t_{Pulssequenz}, sowie die entsprechenden Pulspausen (Duty-Cycle) und die massgebliche Target-Fläche derart ausgewählt werden können, dass sehr niedrige Beschichtungstemperaturen d.h. sehr niedrige Substrattemperaturen während des Beschichtungsprozesses eingehalten werden können, ohne dass Prozessinstabilitäten vorkommen.

Erfindungsgemäß kann man Hartstoffschichten mit unterschiedlichen Farben des Goldstandards durch die Einstellung eines entsprechenden Stickstoffflusses produzieren, aber man kann auch andere Hartstoffschichten dessen Farbeindruck man in einem großen Beschichtungsbereich durch die Einstellung des entsprechend verwendeten Reaktivgasflusses oder der Konzentration von unterschiedlichen Reaktivgassen, einstellen kann.

Im Rahmen der vorliegenden Erfindung wurden beispielsweise dekorative Hartstoffschichten mit vorgegebener Farbe und hervorragend homogenem Farbeindruck, sehr hoher Härte und super glatter Oberfläche erfindungsgemäß hergestellt. Die verwendeten Reaktivgasflüsse sowie die gemessenen mechanischen Eigenschaften der hergestellten Hartstoffschichten sind in der Tabelle 1 eingetragen. Alle Prozesse wurden bei Substrattemperaturen zwischen 150 °C und 500 °C durchgeführt.

**Tabelle 1: Verwendete Reaktivgasflüsse und mechanische Eigenschaften von erfindungsgemäß abgeschiedenen TiN-, TiCN-, und TiC-Hartstoffschichten zur Erreichung verschiedener vorgegebenen homogenen Farben für dekorative Anwendungen**

| Beispiel | Ar [sccm] | N₂ [sccm] | C₂H₂ [sccm] | Härte _{HIT} [GPa] | E-Modul [GPa] |
|---|---|---|---|---|---|
| 1 | 210 | 50 | 0 | 33 | 420 |
| 2 | 210 | 50 | 6 | 32 | 440 |
| 3 | 210 | 50 | 14 | 37 | 400 |
| 4 | 210 | 30 | 20 | 36.3 | 450 |
| 5 | 210 | 40 | 20 | 44 | 462 |
| 6 | 210 | 20 | 24 | 38.3 | 426 |
| 7 | 150 | 30 | 30 | 42.4 | 465 |

Die sehr höhe mechanische Stabilität dieser Hartstoffschichten, bzw. die sehr gute Kombination von Härte und E-Modul, machen es möglich, dass diese Schichten den damit beschichteten Gegenständen ein dauerhaftes farbiges Aussehen verleihen.

Diese Schichten weisen eine sehr gute Haftung zum Substrat auf und haben eine sehr hohe Verschleißbeständigkeit. Infolgedessen können diese dekorative Hartstoffschichten über Jahre lang verwendet werden.

Die Verfahren gemäß der vorliegenden Erfindung machen es möglich, sehr homogenen Farbeindrücke zu erreichen, sogar wenn die Substrate sehr große zu beschichtenden Oberflächen aufweise.

Verfahren gemäß der vorliegenden Erfindung sind insbesondere von Vorteil, wenn mehrere Substrate über die Höhe einer großen Beschichtungskammer verteilt werden müssen und ein homogener Farbeindruck in allen Substraten erreicht werden soll.

## Patentansprüche

1. Verfahren zum Beschichten mindestens von Teilbereichen der Oberfläche eines Substrats bzw. zur Herstellung von Substraten mit einem Oberflächenbereich mit einer dekorativen Hartstoffschicht in einer Beschichtungskammer, wobei zur Herstellung der Hartstoffschicht ein reaktiver HIPIMS-Prozess angewendet wird, bei dem mindestens ein Reaktivgas verwendet wird, und mindestens ein Target aus einem Material verwendet wird, welches bei der Durchführung des HIPIMS-Prozesses mit dem Reaktivgas derart reagieren kann, dass dadurch eine vorgegebene Schichtfarbe produziert wird, wobei der HIPIMS-Prozess unter Verwendung von Leistungspulsen und/oder Leistungspulssequenzen mit einem auf die Target-Fläche bezogenen Energieinhalt von mindestens 0.2 Joule/cm² pro Leistungspuls (1) und/oder pro Leistungspulssequenz (3) durchgeführt wird **dadurch gekennzeichnet, dass** das Target Titan oder Titan und Aluminium oder Zirkon umfasst.

2. Verfahren nach Anspruch 1, **dadurch gekennzeichnet, dass** der auf die Target-Fläche bezogene Energieinhalt in den Leistungspulsen und/oder Leistungspulssequenzen mindestens 1 Joule/cm² pro Leistungspuls (1) bzw. pro Leistungspulssequenz (3) ist.

3. Verfahren nach einem der vorhergehenden Ansprüche, **dadurch gekennzeichnet, dass** der auf die Target-Fläche bezogene Energieinhalt in den Leistungspulsen und/oder Leistungspulssequenzen mindestens 10 Joule/cm² pro Leistungspuls (1) bzw. pro Leistungspulssequenz (3) ist.

4. Verfahren nach einem der vorhergehenden Ansprüche, **dadurch gekennzeichnet, dass** der auf die Target-Fläche bezogene Energieinhalt in den Leistungspulsen und/oder Leistungspulssequenzen unter einer Einstellung der Leistungsdichte pro Leistungspuls (1) und/oder pro Leistungspulssequenz (3) eingebracht wird.

5. Verfahren nach einem der vorhergehenden Ansprüche 1 bis 3, **dadurch gekennzeichnet, dass** der auf die Target-Fläche bezogene Energieinhalt in den Leistungspulsen und/oder Leistungspulssequenzen durch die Einstellung der Dauer des Leistungspulses (t_{Puls}) bzw. der Dauer der Leistungspulssequenz (t_{Pulssequenz}) eingebracht wird.

6. Verfahren nach einem der Ansprüche 4 oder 5, **dadurch gekennzeichnet, dass** eine Leistungsdichte von mindestens 100 W/cm² eingestellt wird.

7. Verfahren nach Anspruch 6, **dadurch gekennzeichnet, dass** eine Leistungsdichte von mindestens 500 W/cm² eingestellt wird.

8. Verfahren nach Anspruch 7, **dadurch gekennzeichnet, dass** eine Leistungsdichte von mindestens 1000 W/cm² eingestellt wird.

9. Verfahren nach einem der vorhergehenden Ansprüche, **dadurch gekennzeichnet, dass** die Dauer eines Leistungspulses, t_{Puls}, oder die Dauer der Einzel-Pulse innerhalb einer Leistungspulssequenz oder die Dauer einer Leistungspulssequenz, t_{Pulssequenz}, sowie die entsprechenden Pulspausen (Duty-Cycle) und die massgebliche Target-Fläche derart ausgewählt werden, dass eine Substrattemperaturen während des Beschichtungsprozesses nicht über 200°C steigt.

10. Verfahren nach einem der vorhergehenden Ansprüche, **dadurch gekennzeichnet, dass** als Reaktivgas Stickstoffgas, Sauerstoffgas oder ein kohlenstoffhaltiges Gas oder eine Mischung derselben verwendet wird.

11. Verfahren nach einem der vorhergehenden Ansprüche, **dadurch gekennzeichnet, dass** das Target aus Titan oder aus Titan und Aluminium oder aus Zirkon besteht.

12. Verfahren nach Anspruch 11, **dadurch gekennzeichnet, dass** das Target aus Titan besteht und als Reaktivgas Stickstoffgas verwendet wird, wobei die Konzentration vom Stickstoffgas in der Beschichtungskammer durch die Regulierung eines Stickstoffgasflusses kontrolliert wird und der Stickstoffgasflusses derart reguliert wird, dass der Farbeneindruck einer Farbe entsprechend derjenigen von Gold 2N18 oder 1N14 oder 3N18 entspricht.

## Claims

1. Method to coat at least a subarea from a substrate surface, respectively to produce substrates having surface areas with a decorative hard coating in a coating compartment, whereat a reactive HIPIMS-process making use of at least one reactive gas is applied and at least one target from a material is used, which by performing the HIPIMS-process with the reactive gas can react in a such a way that a given coating color can be produced, whereat the HIPIMS-process is performed with an energy input per target surface of at least 0.2 Joule/cm² per power pulse (1) and/or per power pulse sequence (3), **characterized in that** the target comprises titanium, or titanium and aluminium, or zirkonium.

2. Method according to claim 1, **characterized in that** the energy input per target surface in power pulses and/or power pulse sequences is at least 1 Joule/cm² per power pulse (1) respectively per power pulse sequence (3).

3. Method according to one of the previous claims, **characterized in that** the energy input per target surface in power pulses and/or power pulse sequences is at least 10 Joule/cm² per power pulse (1) respectively per power pulse sequence (3).

4. Method according to 1 of the previous claims, **characterized in that** the energy input per target surface in power pulses and/or power pulse sequences is performed by adjustment of the power density per power pulse (1) and/or per power pulse sequence (3).

5. Method according to one of the previous claims 1 to 3, **characterized in that** the energy input per target surface in power pulses and/or power pulse sequences is performed by adjustment of the duration of the power pulse (t_{Puls}) respectively the duration of the power pulse sequence (t_{Pulssequence}).

6. Method according to one of the claims 4 or 5, **characterized in that** a power density of at least 100 W/cm² is set.

7. Method according to claim 6, **characterized in that** a power density of at least 500 W/cm² is set.

8. Method according to claims 7, **characterized in that** a power density of at least 100 W/cm² is set.

9. Method according to one of the previous claims, **characterized in that** the duration of a power pulse, t_{Puls}, or the duration of single pulses within a power pulse sequence or the duration of a power pulse sequence (t_{Pulssequence)} as well as the referring pulse pauses (Duty-Cycle) and the referring target-surface is selected in such a way that substrate temperature does not rise above 200°C durring the coating process.

10. Method according to one of the previous claims, **characterized in that** the reactive gas is nitrogen gas, oxygen gas, or carbon containing gas, or a mixture of such gases.

11. Method according to one of the previous claims, **characterized in that** the target is made from titanium, or from titanium and aluminium, or from zikornium.

12. Method according to claim 11, **characterized in that** the target is made from titamium, and nitrogen gas is used as reactive gas, whereat the concentration of nitrogen gas is the coating compartment is controlled by adjusting a nitrogen gas flow and the nitrogen gas flow is controlled in such a way that the color impression comply with a color of gold 2N18, or 1N14, or 3N18.

## Revendications

1. Procédé dd revêtement au moins de portions de la surface d'un substrat ou procédé de fabrication de substrats avec une zone de surface enduite d'une couche décorative de substance dure dans une chambre de dépôt, dans lequel on utilise pour fabriquer la couche de substance dure un processus de pulvérisation réactive HIPIMS, dans lequel il est utilisé au moins un gaz réactif et au moins une cible d'un matériau qui peut réagir lors du processus HIPIMS avec le gaz réactif de sorte qu'il en résulte une couleur de couche prédéterminée, le processus HIPIMS étant réalisé en utilisant des impulsions de puissance et/ou des séquences d'impulsions de puissance avec une teneur en énergie rapportée à la surface cible d'au moins 0,2 Joule/cm² par impulsion de puissance (1) et/ou par séquence d'impulsions de puissance (3), **caractérisé en ce que** la cible comprend du titane, du titane et de l'aluminium ou du zirconium.

2. Procédé selon la revendication 1, **caractérisé en ce que** la teneur en énergie rapportée à la surface cible dans les impulsions de puissance et/ou dans les séquences d'impulsions de puissance est d'au moins 1 Joule/cm² par impulsion de puissance (1) ou par séquence d'impulsions de puissance (3).

3. Procédé selon l'une des revendications précédentes, **caractérisé en ce que** la teneur en énergie rapportée à la surface cible dans les impulsions de puissance et/ou dans les séquences d'impulsions de puissance est d'au moins 10 Joule/cm² par impulsion de puissance (1) ou par séquence d'impulsions de puissance (3).

4. Procédé selon l'une des revendications précédentes, **caractérisé en ce que** la teneur en énergie rapportée à la surface cible dans les impulsions de puissance et/ou dans les séquences d'impulsions de puissance est appliquée suivant un réglage de la densité de puissance par impulsion de puissance (1) et/ou par séquence d'impulsions de puissance (3).

5. Procédé selon l'une des revendications précédentes 1 à 3, **caractérisé en ce que** la teneur en énergie rapportée à la surface cible dans les impulsions de puissance et/ou dans les séquences d'impulsions de puissance est appliquée suivant le réglage de la durée de l'impulsion de puissance (t_{Puls}) ou de la durée de la séquence d'impulsions de puissance (t_{Pulssequenz}).

6. Procédé selon l'une des revendications 4 ou 5, **caractérisé en ce qu'**il est réglé une densité de puissance d'au moins 100 W/cm².

7. Procédé selon la revendication 6, **caractérisé en ce qu'**il est réglé une densité de puissance d'au moins 500 W/cm².

8. Procédé selon la revendication 7, **caractérisé en ce qu'**il est réglé une densité de puissance d'au moins 1000 W/cm².

9. Procédé selon l'une des revendications précédentes, **caractérisé en ce que** la durée d'une impulsion de puissance, t_{Puls}, ou la durée d'une seule impulsion dans une séquence d'impulsions de puissance, ou la durée d'une séquence d'impulsions de puissance, t_{Pulssequenz}, ainsi que les intervalles correspondants entre les impulsions (Duty-Cycle) et les surfaces cibles essentielles sont choisis de sorte que la température de substrat ne monte pas au-delà de 200°C pendant le processus d'enduction.

10. Procédé selon l'une des revendications précédentes, **caractérisé en ce qu'**il est utilisé comme gaz réactif de l'azote gazeux, de l'oxygène gazeux ou un gaz carboné ou encore un mélange de ces derniers.

11. Procédé selon l'une des revendications précédentes, **caractérisé en ce que** la cible est composée de titane, de titane et d'aluminium ou de zirconium.

12. Procédé selon la revendication 11, **caractérisé en ce que** la cible est composée de titane et **en ce qu'**on utilise comme gaz réactif de l'azote gazeux, la concentration d'azote gazeux dans la chambre de dépôt étant contrôlée par la régulation d'un flux d'azote gazeux et le flux d'azote gazeux étant régulé de sorte que l'impression d'une couleur corresponde à Gold 2N18 ou 1N14 ou 3N18.
